# EUROPEAN PATENT APPLICATION

(11) **EP 2 355 165 A1**
(43) Date of publication of application: **10.08.2011**
(21) Application number: 09830225.0
(22) Date of filing: 07.01.2009
(51) Int. Cl.: H01L 31/04

(54) **PHOTOELECTRIC CONVERSION DEVICE**

(30) Priority: 05.12.2008 JP 2008311301
(71) Applicant: Mitsubishi Heavy Industries, Ltd., Tokyo 108-8215 (JP)
(72) Inventor: GOYA, Saneyuki, Yokohama-shi Kanagawa 236-8515 (JP); KOBAYASHI, Yasuyuki, Yokohama-shi Kanagawa 236-8515 (JP); SAKAI, Satoshi, Yokohama-shi Kanagawa 236-8515 (JP)
(74) Representative: Bongiovanni, Simone
(86) International application number: PCT/JP2009/050100
(87) International publication number: WO 2010/064455

(57) **Abstract**

A film thickness configuration for a triple-junction photovoltaic device that is suitable for obtaining high conversion efficiency. The photovoltaic device (100) comprises, on top of a substrate (1), a transparent electrode layer (2), a photovoltaic layer (3) containing three stacked cell layers (91, 92, 93) having pin junctions, and a back electrode layer (4), wherein an incident section cell layer (91) provided on the light-incident side has an amorphous silicon i-layer having a thickness of not less than 100 nm and not more than 200 nm, a bottom section cell layer (93) provided on the opposite side from the light-incident side has a crystalline silicon-germanium i-layer having a thickness of not less than 700 nm and not more than 1,600 nm, and the ratio of germanium atoms relative to the sum of germanium atoms and silicon atoms within the crystalline silicon-germanium i-layer is not less than 15 atomic% and not more than 25 atomic%, and a middle section cell layer (92) provided between the incident section cell layer (91) and the bottom section cell layer (93) has a crystalline silicon i-layer having a thickness of not less than 1,000 nm and not more than 2,000 nm.

## Description

### Technical Field

The present invention relates to a photovoltaic device, and relates particularly to a triple-junction solar cell.

### Background Art

One known example of a photovoltaic device used in a solar cell that converts the energy from sunlight into electrical energy is a thin-film silicon-based photovoltaic device comprising a photovoltaic layer having a pin junction formed by using a plasma-enhanced CVD method or the like to deposit thin films of a p-type silicon-based semiconductor (p-layer), an i-type silicon-based semiconductor (i-layer) and an n-type silicon-based semiconductor (n-layer).

Advantages of thin-film silicon-based photovoltaic devices include the fact that the surface area can be increased relatively easily compared with crystalline photovoltaic devices, and the fact that the thickness of the photovoltaic layer is approximately 1/100th that of a crystalline photovoltaic device, meaning production is possible with minimal material. As a result, compared with crystalline photovoltaic devices, both the time and the cost required to produce the photovoltaic layer can be reduced. In contrast, drawbacks of thin-film silicon-based photovoltaic devices include lower conversion efficiency than that of crystalline photovoltaic devices.

Known methods of improving the conversion efficiency, besides improving the film quality of the thin-film silicon material (such as amorphous silicon, amorphous silicon germanium or microcrystalline silicon), include the use of multi-junction photovoltaic devices having a plurality of stacked photovoltaic layers that exhibit different band gaps, and particularly triple-junction photovoltaic devices in which three photovoltaic layers are stacked together. The main reasons for the improvement in conversion efficiency are that by combining photovoltaic layers with different band gaps, solar energy across a wide wavelength band can be utilized effectively, and the fact that the photon energy conversion efficiency within each conversion element can be improved.

Examples of triple-junction photovoltaic devices that are employed include structures in which an amorphous silicon layer, a microcrystalline silicon layer and a microcrystalline silicon-germanium layer are stacked, as photovoltaic layers, in that order from the light-incident side of the device (see Patent Citation 1), and structures in which an amorphous silicon layer, and two amorphous silicon-germanium layers are stacked, in that order, from the light-incident side of the device (see Patent Citation 2).
Patent Citation 1: Japanese Unexamined Patent Application, Publication No. Hei 10-125944
Patent Citation 2: Japanese Unexamined Patent Application, Publication No. Hei 7-297420

### Disclosure of Invention

Patent Citation 1 discloses that in order to prepare a photovoltaic element having excellent conversion efficiency and a reduced light-induced degradation rate, a photovoltaic element having a plurality of pin junctions and formed as a stacked cell structure wherein, when counted from the light-incident side of the element, the i-type semiconductor layer of the first pin junction comprises amorphous silicon, the i-type semiconductor layer of the second pin junction comprises microcrystalline silicon, and the i-type semiconductor layer of the third pin junction comprises microcrystalline silicon-germanium is particularly effective. Further, Patent Citation 1 also discloses that in order to obtain a conversion efficiency that is sufficiently stable for practical purposes, the Ge composition ratio within the microcrystalline SiGe must be not less than 45%. The reason for this requirement is that as the Ge concentration is increased, the band gap narrows, enabling longer wavelength light to be absorbed more efficiently.

However, during the process of attempting to improve the film quality of the microcrystalline silicon-germanium in order to improve the conversion efficiency of a thin-film silicon solar cell, it was found that in a similar manner to that observed for amorphous silicon-germanium films, a microcrystalline silicon-germanium film tends to suffer from deteriorating film quality as the Ge concentration is increased. As a result, it was discovered that even in the case of a high Ge concentration (namely, a Ge concentration of not less than 45%) that might be expected to exhibit a high level of sensitivity to longer wavelength light, the electric power generation current did not increase, but rather, the performance actually decreased. It is surmised that the reason for these observations is because at high Ge concentrations, the microcrystalline silicon-germanium essentially transitions from an i-type structure to a p-type structure.

The present invention has been developed in light of the above circumstances, and provides a film thickness configuration for a triple-junction photovoltaic device that is suitable for obtaining high conversion efficiency.

It is thought that the reason a high Ge concentration causes transition of the microcrystalline silicon-germanium to a p-type structure is due to the large number of defects such as dangling bonds that exist within the film, with these defects acting as hole supply sources. In the present invention, a triple-junction structure photovoltaic device that maximizes the long wavelength sensitivity inherent to microcrystalline silicon-germanium is realized under conditions in which the Ge concentration within the microcrystalline silicon-germanium is reduced to a lower concentration to enable the transition to a p-type structure to be suppressed.

In other words, a photovoltaic device of the present invention comprises, on top of a substrate, a transparent electrode layer, a photovoltaic layer containing three stacked cell layers having pin junctions, and a back electrode layer, wherein an incident section cell layer provided on the light-incident side among the cell layers has an amorphous silicon i-layer having a thickness of not less than 100 nm and not more than 200 nm, a bottom section cell layer provided on the opposite side from the light-incident side among the cell layers has a crystalline silicon-germanium i-layer having a thickness of not less than 700 nm and not more than 1,600 nm, and a ratio of germanium atoms relative to the sum of germanium atoms and silicon atoms within the crystalline silicon-germanium i-layer is not less than 15 atomic% and not more than 25 atomic%, and a middle section cell layer provided between the incident section cell layer and the bottom section cell layer has a crystalline silicon i-layer having a thickness of not less than 800 nm and not more than 2,000 nm.

In this type of photovoltaic device comprising a photovoltaic layer containing three stacked cell layers, if the ratio of germanium atoms relative to the sum of germanium atoms and silicon atoms within the crystalline silicon-germanium i-layer of the bottom section cell layer is not less than 15 atomic% and not more than 25 atomic%, then provided the thickness of the i-layer within each cell layer satisfies the respective range described above, a photovoltaic device having high conversion efficiency can be obtained.

In this case, the ratio of the thickness of the crystalline silicon-germanium i-layer relative to the thickness of the crystalline silicon i-layer is preferably not less than 0.6 and not more than 1.0.

Investigations by the inventors of the present invention revealed that a strong correlation existed between the ratio of the thickness of the crystalline silicon-germanium i-layer relative to the thickness of the crystalline silicon i-layer and the conversion efficiency. Accordingly, provided the ratio of the thickness of the crystalline silicon-germanium i-layer relative to the thickness of the crystalline silicon i-layer is not less than 0.6 and not more than 1.0, and preferably not less than 0.7 and not more than 1.0, a photovoltaic device having high conversion efficiency can be obtained with good reliability.

A photovoltaic device according to another aspect of the present invention comprises, on top of a substrate, a transparent electrode layer, a photovoltaic layer containing three stacked cell layers having pin junctions, and a back electrode layer, wherein an incident section cell layer provided on the light-incident side among the cell layers has an amorphous silicon i-layer having a thickness of not less than 150 nm and not more than 250 nm, a bottom section cell layer provided on the opposite side from the light-incident side among the cell layers has a crystalline silicon-germanium i-layer having a thickness of not less than 1,000 nm and not more than 3,000 nm, and a ratio of germanium atoms relative to the sum of germanium atoms and silicon atoms within the crystalline silicon-germanium i-layer is not less than 25 atomic% and not more than 35 atomic%, and a middle section cell layer provided between the incident section cell layer and the bottom section cell layer has a crystalline silicon i-layer having a thickness of not less than 1,000 nm and not more than 3,000 nm.

In this type of photovoltaic device comprising a photovoltaic layer containing three stacked cell layers, if the ratio of germanium atoms relative to the sum of germanium atoms and silicon atoms within the crystalline silicon-germanium i-layer of the bottom section cell layer is not less than 25 atomic% and not more than 35 atomic%, then provided the thickness of the i-layer within each cell layer satisfies the respective range described above, a photovoltaic device having high conversion efficiency can be obtained.

In this case, the ratio of the thickness of the crystalline silicon-germanium i-layer relative to the thickness of the crystalline silicon i-layer is preferably not less than 0.9 and not more than 1.6.

Provided the ratio of the thickness of the crystalline silicon-germanium i-layer relative to the thickness of the crystalline silicon i-layer is not less than 0.9 and not more than 1.6, and preferably not less than 1 and not more than 1.6, a photovoltaic device having high conversion efficiency can be obtained with good reliability.

A photovoltaic device according to yet another aspect of the present invention comprises, on top of a substrate, a transparent electrode layer, a photovoltaic layer containing three stacked cell layers having pin junctions, and a back electrode layer, wherein an incident section cell layer provided on the light-incident side among the cell layers has an amorphous silicon i-layer having a thickness of not less than 150 nm and not more than 300 nm, a bottom section cell layer provided on the opposite side from the light-incident side among the cell layers has a crystalline silicon-germanium i-layer having a thickness of not less than 1,000 nm and not more than 2,000 nm, and a ratio of germanium atoms relative to the sum of germanium atoms and silicon atoms within the crystalline silicon-germanium i-layer is not less than 35 atomic% and not more than 45 atomic%, and a middle section cell layer provided between the incident section cell layer and the bottom section cell layer has a crystalline silicon i-layer having a thickness of not less than 1,000 nm and not more than 2,500 nm.

In this type of photovoltaic device comprising a photovoltaic layer containing three stacked cell layers, if the ratio of germanium atoms relative to the sum of germanium atoms and silicon atoms within the crystalline silicon-germanium i-layer of the bottom section cell layer is not less than 35 atomic% and not more than 45 atomic%, then provided the thickness of the i-layer within each cell layer satisfies the respective range described above, a photovoltaic device having high conversion efficiency can be obtained.

In this case, the ratio of the thickness of the crystalline silicon-germanium i-layer relative to the thickness of the crystalline silicon i-layer is preferably not less than 0.7 and not more than 1.2.

Provided the ratio of the thickness of the crystalline silicon-germanium i-layer relative to the thickness of the crystalline silicon i-layer is not less than 0.7 and not more than 1.2, and preferably not less than 0.8 and not more than 1.1, a photovoltaic device having high conversion efficiency can be obtained with good reliability.

In the invention described above, an intermediate contact layer may be provided between the incident section cell layer and the middle section cell layer.

By providing an intermediate contact layer, the thickness of the incident section cell layer can be reduced and light-induced degradation can be suppressed, meaning a more stabilized output can be obtained.

In the invention described above, a second transparent electrode layer may be provided between the bottom section cell layer and the back electrode layer.

By providing a second transparent electrode layer between the bottom section cell layer and the back electrode layer, the electric field intensity distribution of light penetrating into the interior of the back electrode layer becomes shallower and smaller, meaning the amount of light absorbed by the back electrode layer can be reduced.

In a photovoltaic device comprising a photovoltaic layer containing three stacked cell layers according to the present invention, by setting the thickness of the i-layer within each cell layer in the manner described above, in accordance with the ratio of germanium atoms relative to the sum of germanium atoms and silicon atoms within the crystalline silicon-germanium i-layer of the bottom section cell layer, a photovoltaic device having high conversion efficiency can be obtained.

### Brief Description of Drawings

[FIG. 1] A cross-sectional view schematically illustrating the structure of a photovoltaic device according to a first embodiment of the present invention.
[FIG. 2] A schematic illustration describing an embodiment for producing a solar cell panel that represents a photovoltaic device according to the present invention.
[FIG. 3] A schematic illustration describing an embodiment for producing a solar cell panel that represents a photovoltaic device according to the present invention.
[FIG. 4] A schematic illustration describing an embodiment for producing a solar cell panel that represents a photovoltaic device according to the present invention.
[FIG. 5] A schematic illustration describing an embodiment for producing a solar cell panel that represents a photovoltaic device according to the present invention.
[FIG. 6] A graph illustrating the relationship between the thickness of the crystalline silicon i-layer of a second cell layer and the conversion efficiency for a solar cell of example 1.
[FIG. 7] A graph illustrating the relationship between the thickness of the crystalline silicon-germanium i-layer of a third cell layer and the conversion efficiency for the solar cell of example 1.
[FIG. 8] A graph illustrating the relationship between the ratio of the thickness of the crystalline silicon-germanium i-layer relative to the thickness of the crystalline silicon i-layer and the conversion efficiency for the solar cell of example 1.
[FIG. 9] A graph illustrating the relationship between the thickness of the crystalline silicon i-layer of a second cell layer and the conversion efficiency for a solar cell of example 2.
[FIG. 10] A graph illustrating the relationship between the thickness of the crystalline silicon-germanium i-layer of a third cell layer and the conversion efficiency for the solar cell of example 2.
[FIG. 11] A graph illustrating the relationship between the ratio of the thickness of the crystalline silicon-germanium i-layer relative to the thickness of the crystalline silicon i-layer and the conversion efficiency for the solar cell of example 2.
[FIG. 12] A graph illustrating the relationship between the thickness of the crystalline silicon i-layer of a second cell layer and the conversion efficiency for a solar cell of example 3.
[FIG. 13] A graph illustrating the relationship between the thickness of the crystalline silicon-germanium i-layer of a third cell layer and the conversion efficiency for the solar cell of example 3.
[FIG. 14] A graph illustrating the relationship between the ratio of the thickness of the crystalline silicon-germanium i-layer relative to the thickness of the crystalline silicon i-layer and the conversion efficiency for the solar cell of example 3.

### Explanation of Reference:

- 1:: Substrate
- 2:: First transparent electrode layer
- 3:: Photovoltaic layer
- 4:: Back electrode layer
- 5:: Second transparent electrode layer
- 91:: First cell layer
- 92:: Second cell layer
- 93:: Third cell layer
- 100:: Photovoltaic device

### Best Mode for Carrying Out the Invention

### First Embodiment

A description of the structure of a photovoltaic device according to a first embodiment of the present invention is presented below.

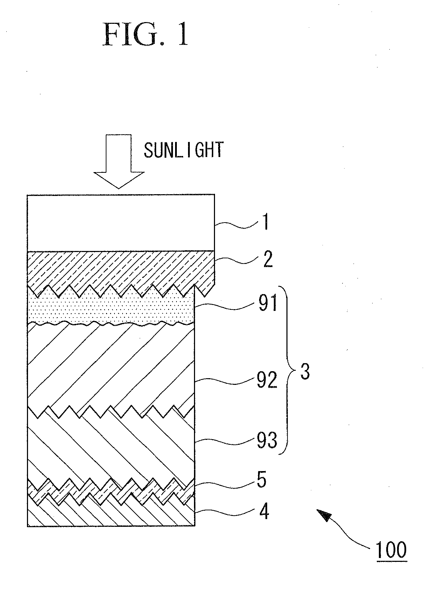

FIG. 1 is a schematic illustration of the structure of a photovoltaic device according to this embodiment. A photovoltaic device 100 is a silicon-based solar cell, and comprises a substrate 1, a first transparent electrode layer 2, a photovoltaic layer 3, a second transparent electrode layer 5, and a back electrode layer 4. The photovoltaic layer 3 comprises a first cell layer 91 (the incident section cell layer) containing an amorphous silicon i-layer, a second cell layer 92 (the middle section cell layer) containing a crystalline silicon i-layer, and a third cell layer 93 (the bottom section cell layer) containing a crystalline silicon-germanium i-layer. Here, the term "crystalline silicon" describes a silicon other than amorphous silicon, and includes both microcrystalline silicon and polycrystalline silicon.

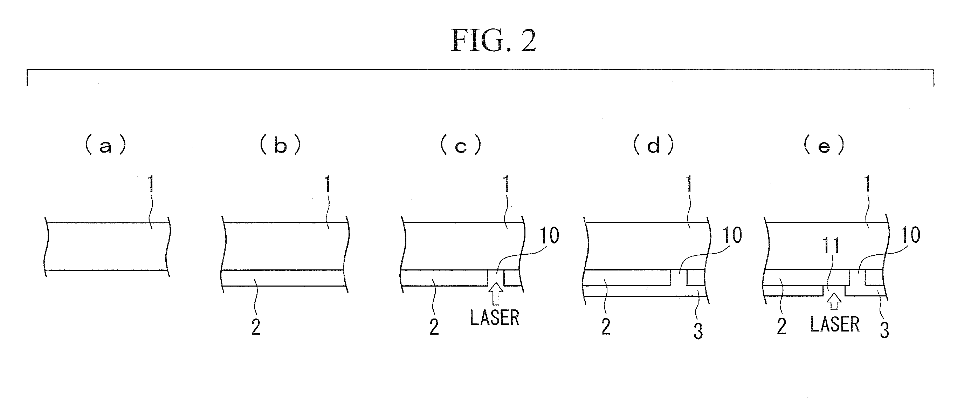

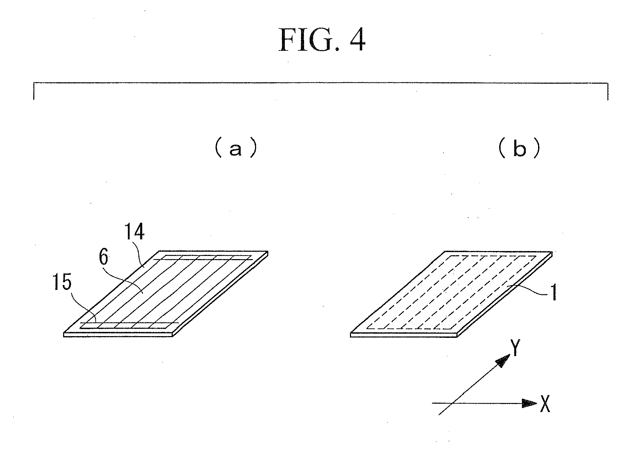

A description of the steps for producing a solar cell panel as an example of the photovoltaic device according to the present embodiment is presented below, with reference to FIG. 2 through FIG. 5.

### (1) FIG. 2(a)

A soda float glass substrate (for example, a large surface area substrate of 1.4 m × 1.1 m × thickness: 3 to 6 mm, where the length of one side exceeds 1 m) is used as the substrate 1. The edges of the substrate are preferably subjected to corner chamfering or R-face chamfering to prevent damage caused by thermal stress or impacts or the like.

### (2) FIG. 2(b)

A transparent electrode film comprising mainly tin oxide (SnO₂) and having a film thickness of approximately not less than 500 nm and not more than 800 nm is deposited as the first transparent electrode layer 2 using a thermal CVD apparatus at a temperature of approximately 500°C. During this deposition, a texture comprising suitable asperity is formed on the surface of the transparent electrode film. In addition to the transparent electrode film, the transparent electrode layer 2 may include an alkali barrier film (not shown in the figure) formed between the substrate 1 and the transparent electrode film. The alkali barrier film is formed using a thermal CVD apparatus at a temperature of approximately 500°C to deposit a silicon oxide film (SiO₂) having a film thickness of not less than 50 nm and not more than 150 nm.

### (3) FIG. 2(c)

Subsequently, the substrate 1 is mounted on an X-Y table, and the first harmonic of a YAG laser (1064 nm) is irradiated onto the surface of the transparent electrode layer, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

### (4) FIG. 2(d)

Using a plasma-enhanced CVD apparatus, an amorphous silicon p-layer, an amorphous silicon i-layer and a crystalline silicon n-layer are deposited as the first cell layer 91. Using SiH₄ gas and H₂ gas as the main raw materials, and under conditions including a reduced pressure atmosphere of not less than 30 Pa and not more than 1,000 Pa and a substrate temperature of approximately 200°C, the p-layer, the i-layer and the n-layer are deposited, in that order, on the transparent electrode layer 2, with the p-layer closest to the surface from which incident sunlight enters. The amorphous silicon p-layer is an amorphous boron-doped silicon film having a film thickness of not less than 10 nm and not more than 30 nm. The amorphous silicon i-layer has a film thickness of not less than 100 nm and not more than 200 nm, and preferably not less than 120 nm and not more than 160 nm. The crystalline silicon n-layer is a phosphorus-doped crystalline silicon film having a film thickness of not less than 30 nm and not more than 50 nm. A buffer layer may be provided between the amorphous silicon p-layer and the amorphous silicon i-layer in order to improve the interface properties.

Using a plasma-enhanced CVD apparatus, a p-layer, an i-layer and an n-layer, each composed of a thin film of crystalline silicon, are deposited as the second cell layer 92 on top of the first cell layer 91. The p-layer, the i-layer and the n-layer are deposited, in that order, using SiH₄ gas and H₂ gas as the main raw materials, and under conditions including a reduced pressure atmosphere of not more than 3,000 Pa, a substrate temperature of approximately 200°C and a plasma generation frequency of not less than 40 MHz and not more than 100 MHz. The crystalline silicon p-layer is a boron-doped crystalline silicon film having a film thickness of not less than 10 nm and not more than 50 nm. The crystalline silicon i-layer has a film thickness of not less than 1,000 nm and not more than 2,000 nm, and preferably not less than 1,000 nm and not more than 1,600 nm. The crystalline silicon n-layer is a phosphorus-doped crystalline silicon film having a film thickness of not less than 20 nm and not more than 50 nm.

Using a plasma-enhanced CVD apparatus, a p-layer and an n-layer, each composed of a thin film of crystalline silicon, and an i-layer composed of a thin film of crystalline silicon-germanium are deposited as the third cell layer 93 on top of the second cell layer 92. The p-layer, the i-layer and the n-layer are deposited, in that order, using SiH₄ gas, GeH₄ gas and H₂ gas as the main raw materials, and under conditions including a reduced pressure atmosphere of not more than 3,000 Pa, a substrate temperature of approximately 200°C and a plasma generation frequency of not less than 40 MHz and not more than 100 MHz. The GeH₄ gas is not used during deposition of the p-layer and the n-layer. The ratio of germanium atoms relative to the sum of germanium atoms and silicon atoms within the crystalline silicon-germanium i-layer (hereinafter referred to as the "Ge composition ratio") is controlled by adjusting the flow rate ratio between the raw material gases. In the present embodiment, the Ge composition ratio is not less than 15 atomic% and not more than 25 atomic%. The crystalline silicon p-layer is a boron-doped crystalline silicon film, and has a film thickness of not less than 10 nm and not more than 50 nm. The thickness of the crystalline silicon-germanium i-layer is not less than 700 nm and not more than 1,600 nm, and preferably not less than 800 nm and not more than 1,200 nm. The crystalline silicon n-layer is a phosphorus-doped crystalline silicon film, and has a film thickness of not less than 10 nm and not more than 50 nm.

In the present embodiment, the ratio of the thickness of the crystalline silicon-germanium i-layer of the third cell layer 93 relative to the thickness of the crystalline silicon i-layer of the second cell layer 92 is not less than 0.6 and not more than 1.0, and preferably not less than 0.7 and not more than 1.0.

An intermediate contact layer that functions as a semi-reflective film for improving the contact properties between the first cell layer 91 and the second cell layer 92 and achieving electrical current consistency may be provided on the first cell layer 91. For example, a GZO (Ga-doped ZnO) film with a film thickness of not less than 20 nm and not more than 100 nm may be formed as the intermediate contact layer using a DC sputtering apparatus with a Ga-doped ZnO sintered body as the target.

### (5) FIG. 2(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to not less than 10 kHz and not more than 20 kHz, the laser power is adjusted so as to achieve a suitable process speed, and laser etching is conducted at a point approximately 100 µm to 150 µm to the side of the laser etching line within the transparent electrode layer 2, so as to form a slot 11. The laser may also be irradiated from the side of the substrate 1. In this case, because the high vapor pressure generated by the energy absorbed by the first cell layer 91 of the photovoltaic layer 3 can be utilized, more stable laser etching can be performed. The position of the laser etching line is determined with due consideration of positioning tolerances, so as not to overlap with the previously formed etching line.

### (6) FIG. 3(a)

Using a sputtering apparatus, an Ag film is then deposited as the back electrode layer 4 under a reduced pressure atmosphere and at a temperature of approximately 150°C. In this embodiment, the back electrode layer 4 is formed by sequentially stacking an Ag film having a thickness of not less than 200 nm and not more than 500 nm, and a highly corrosion-resistant Ti film having a thickness of not less than 10 nm and not more than 20 nm which acts as a protective film. An Al film of not less than 250 nm and not more than 350 nm may be used instead of the Ti film. By using Al instead of Ti, the material costs can be reduced while maintaining the anticorrosion effect.

In order to reduce the contact resistance between the n-layer of the third cell layer and the back electrode layer 4 and improve the reflectance, a ZnO-based film (such as a GZO (Ga-doped ZnO) film) with a film thickness of not less than 50 nm and not more than 100 nm may be deposited between the photovoltaic layer 3 and the back electrode layer 4 using a sputtering apparatus.

### (7) FIG. 3(b)

The substrate 1 is mounted on an X-Y table, and the second harmonic of a laser diode excited YAG laser (532 nm) is irradiated onto the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 µm to 400 µm to the side of the laser etching line within the transparent electrode layer 2, so as to form a slot 12.

### (8) FIG. 3(c)

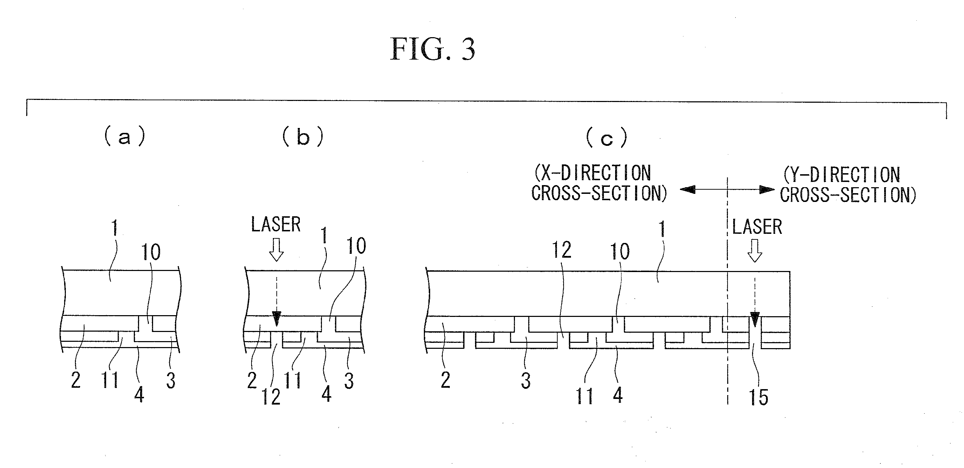

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). A Y-direction insulation slot need not be provided at this point, because a film surface polishing and removal treatment is conducted on the peripheral regions of the substrate 1 in a later step.

Completing the etching of the insulation slot 15 at a position 5 mm to 10 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YVO4 laser or fiber laser or the like may also be used in a similar manner.

### (9) FIG. 4 (a)

In order to ensure favorable adhesion and sealing of a backing sheet 24 via EVA or the like in a subsequent step, the stacked films around the periphery of the substrate 1 (in a peripheral region 14) are removed, as they tend to be uneven and prone to peeling. Grinding or blast polishing or the like is used to remove the back electrode layer 4, the photovoltaic layer 3, and the transparent electrode layer 2 from a region that is 5 mm to 20 mm from the edge around the entire periphery of the substrate 1, is closer to the substrate edge than the insulation slot 15 provided in the above step of FIG. 3(c) in the X direction, and is closer to the substrate edge than the slot 10 near the substrate edge in the Y direction. Grinding debris or abrasive grains are removed by washing the substrate 1.

### (10) FIG. 4 (b)

A terminal box attachment portion is prepared by providing an open through-window in the backing sheet 24 and exposing a collecting plate. A plurality of layers of an insulating material are provided in this open through-window portion in order to prevent external moisture and the like entering the solar cell module.

Processing is conducted so as to enable current collection, using a copper foil, from the series-connected solar cell electric power generation cell at one end, and the solar cell electric power generation cell at the other end, thus enabling electric power to be extracted from the terminal box portion on the rear surface of the solar cell panel. In order to prevent short circuits between the copper foil and the various portions, an insulating sheet that is wider than the width of the copper foil is provided.

Following arrangement of the collecting copper foil and the like at predetermined positions, the entire solar cell module 6 is covered with a sheet of an adhesive filling material such as EVA (ethylene-vinyl acetate copolymer), which is arranged so as not to protrude beyond the substrate 1.

A backing sheet 24 with a superior waterproofing effect is positioned on top of the EVA. In this embodiment, in order to achieve a superior waterproofing and moisture-proofing effect, the backing sheet 24 is formed as a three-layer structure comprising a PET sheet, an Al foil, and a PET sheet.

The structure comprising the components up to and including the backing sheet 24 arranged in predetermined positions is subjected to internal degassing under a reduced pressure atmosphere and under pressing at approximately 150°C to 160°C using a laminator, thereby causing cross-linking of the EVA that tightly seals the structure.

### (11) FIG. 5(a)

A terminal box 23 is attached to the back of the solar cell module 6 using an adhesive.

### (12) FIG. 5(b)

The copper foil and an output cable from the terminal box 23 are connected using solder or the like, and the interior of the terminal box is filled and sealed with a sealant (a potting material). This completes the production of the solar cell panel 50.

### (13) FIG. 5(c)

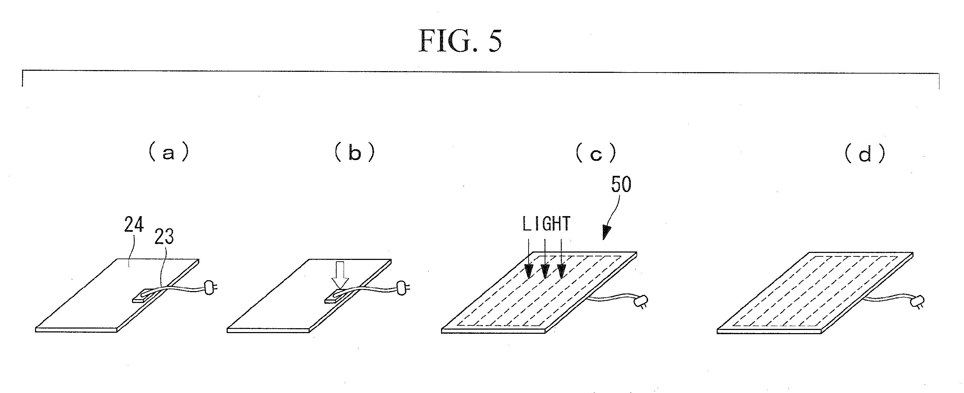

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 W/m²).

### (14) FIG. 5(d)

In tandem with the electric power generation test (FIG. 5(c)), a variety of specific performance factors including the external appearance are evaluated.

### Second Embodiment

In a photovoltaic device according to a second embodiment of the present invention, the thickness of the amorphous silicon i-layer of the first cell layer 91 is not less than 150 nm and not more than 250 nm, and preferably not less than 160 nm and not more than 200 nm. The thickness of the crystalline silicon i-layer of the second cell layer 92 is not less than 1,000 nm and not more than 3,000 nm, and preferably not less than 1,600 nm and not more than 2,400 nm. The Ge composition ratio within the crystalline silicon-germanium i-layer of the third cell layer 93 is not less than 25 atomic% and not more than 35 atomic%, and the thickness of the i-layer is not less than 1,000 nm and not more than 3,000 nm, and preferably not less than 1,500 nm and not more than 2,500 nm.

In the second embodiment, the ratio of the thickness of the crystalline silicon-germanium i-layer of the third cell layer 93 relative to the thickness of the crystalline silicon i-layer of the second cell layer 92 is not less than 0.9 and not more than 1.6, and preferably not less than 1.1 and not more than 1.6.

### Third Embodiment

In a photovoltaic device according to a third embodiment of the present invention, the thickness of the amorphous silicon i-layer of the first cell layer 91 is not less than 150 nm and not more than 300 nm, and preferably not less than 160 nm and not more than 240 nm. The thickness of the crystalline silicon i-layer of the second cell layer 92 is not less than 1,000 nm and not more than 2,500 nm, and preferably not less than 1,400 nm and not more than 2,000 nm. The Ge composition ratio within the crystalline silicon-germanium i-layer of the third cell layer 93 is not less than 35 atomic% and not more than 45 atomic%, and the thickness of the i-layer is not less than 1,000 nm and not more than 2,000 nm, and preferably not less than 1,200 nm and not more than 1,800 nm.

In the third embodiment, the ratio of the thickness of the crystalline silicon-germanium i-layer of the third cell layer 93 relative to the thickness of the crystalline silicon i-layer of the second cell layer 92 is not less than 0.7 and not more than 1.2, and preferably not less than 0.8 and not more than 1.1.

### Examples

### Example 1

Using a structural model for a solar cell comprising the first transparent electrode layer 2, the first cell layer 91, the second cell layer 92, the third cell layer 93, the second transparent electrode layer 5 and the back electrode layer 4 stacked sequentially on top of a glass substrate, optical analysis calculations were performed using the FDTD (Finite Difference Time Domain) method for the case where light enters from the glass substrate side of the solar cell.

The first transparent electrode layer 2 was assumed to have a textured structure with chevron-shaped asperity existing at the interface with the first cell layer. The thickness of the first transparent electrode layer 2 was set to 700 nm, the average pitch (the width of a single cycle) of the textured structure was not less than 400 nm and not more than 800 nm, and the elevation angle (the angle from the surface of the glass substrate) was set to 30°.

In the first cell layer 91, the thickness of the amorphous silicon p-layer was set to 10 nm, and the thickness of the crystalline silicon n-layer was set to 40 nm. The thickness of the amorphous silicon i-layer was set to 120 nm, 140 nm or 160 nm.

In the second cell layer 92, the thickness of the crystalline silicon p-layer was set to 30 nm, and the thickness of the crystalline silicon n-layer was set to 30 nm. The thickness of the crystalline silicon i-layer was set to an appropriate value within a range from 1,000 nm to 1,600 nm.

In the third cell layer 93, the thickness of the crystalline silicon p-layer was set to 30 nm, and the thickness of the crystalline silicon n-layer was set to 30 nm. The Ge composition ratio of the crystalline silicon-germanium i-layer was set to 20 atomic%, and the thickness was set to an appropriate value within a range from 800 nm to 1,200 nm.

The second transparent electrode layer 5 was a GZO film having a film thickness of 80 nm. The back electrode layer 4 was an Ag film having a film thickness of 160 nm.

It was assumed that the interface of each layer from the first cell layer through to the back electrode layer had the same shape as that of the first transparent electrode layer. Further, the medium data for each layer of the first cell layer through to the third cell layer used values obtained by actual measurement of the electrical current performance. Accordingly, because the calculations included consideration of current loss caused by electron recombination, results were able to be obtained that were close to the values for the conversion efficiency of an actual solar cell.

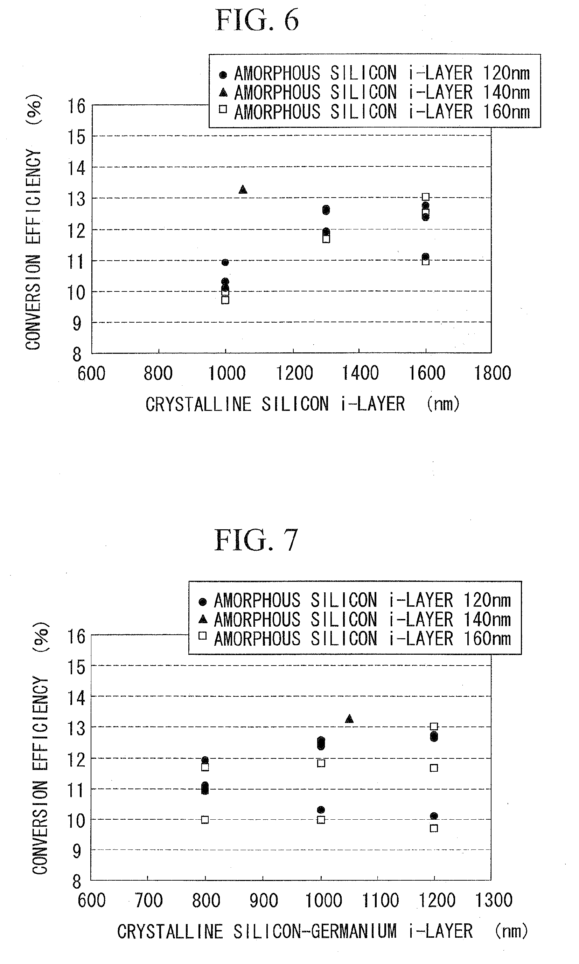

FIG. 6 is a graph illustrating the relationship between the thickness of the crystalline silicon i-layer of the second cell layer and the conversion efficiency for a solar cell of example 1. In the figure, the horizontal axis represents the thickness of the crystalline silicon i-layer, and the vertical axis represents the conversion efficiency. FIG. 7 is a graph illustrating the relationship between the thickness of the crystalline silicon-germanium i-layer of the third cell layer and the conversion efficiency for a solar cell of example 1. In the figure, the horizontal axis represents the thickness of the crystalline silicon-germanium i-layer, and the vertical axis represents the conversion efficiency. Even for identical values for the thickness of the crystalline silicon i-layer and the crystalline silicon-germanium i-layer, considerable variation was observed in the conversion efficiency.

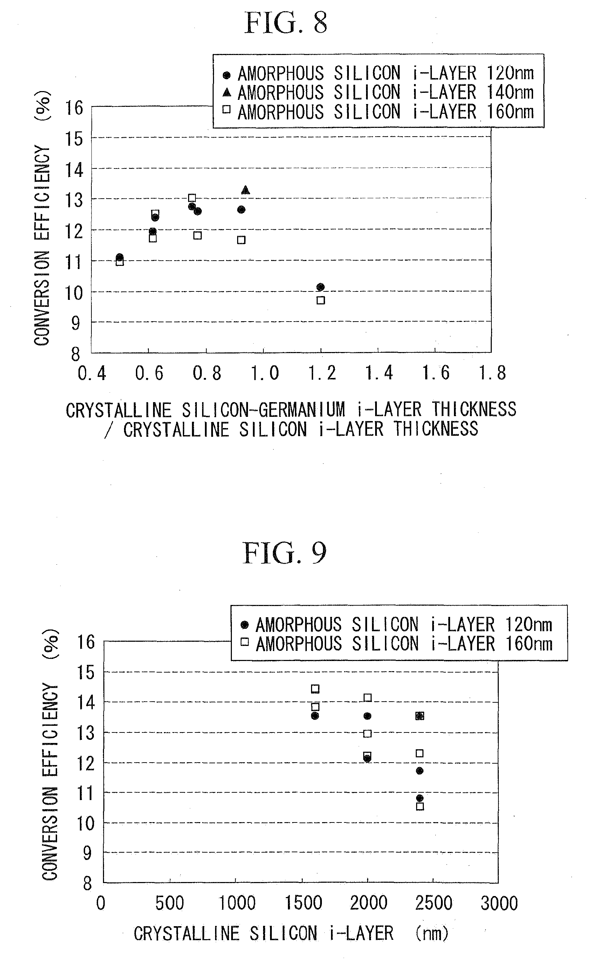

FIG. 8 is a graph illustrating the relationship between the ratio of the thickness of the crystalline silicon-germanium i-layer relative to the thickness of the crystalline silicon i-layer and the conversion efficiency for the solar cell of example 1. In the figure, the horizontal axis represents the thickness ratio ([thickness of the crystalline silicon-germanium i-layer]/[thickness of the crystalline silicon i-layer]), and the vertical axis represents the conversion efficiency. For thickness ratios within a range from not less than 0.6 to not more than 1.0, the conversion efficiency of the solar cell reached approximately 12 to 13%, indicating that a high conversion efficiency was able to be achieved.

### Example 2

Optical analysis calculations were performed using the same solar cell structural model as that of example 1. In example 2, the thickness of the amorphous silicon i-layer of the first cell layer 91 was set to 120 nm or 160 nm. The thickness of the crystalline silicon i-layer of the second cell layer 92 was set to an appropriate value within a range from 1,600 nm to 2,400 nm. The Ge composition ratio of the crystalline silicon-germanium i-layer of the third cell layer 93 was set to 30 atomic%, and the thickness was set to an appropriate value within a range from 1,500 nm to 2,500 nm.

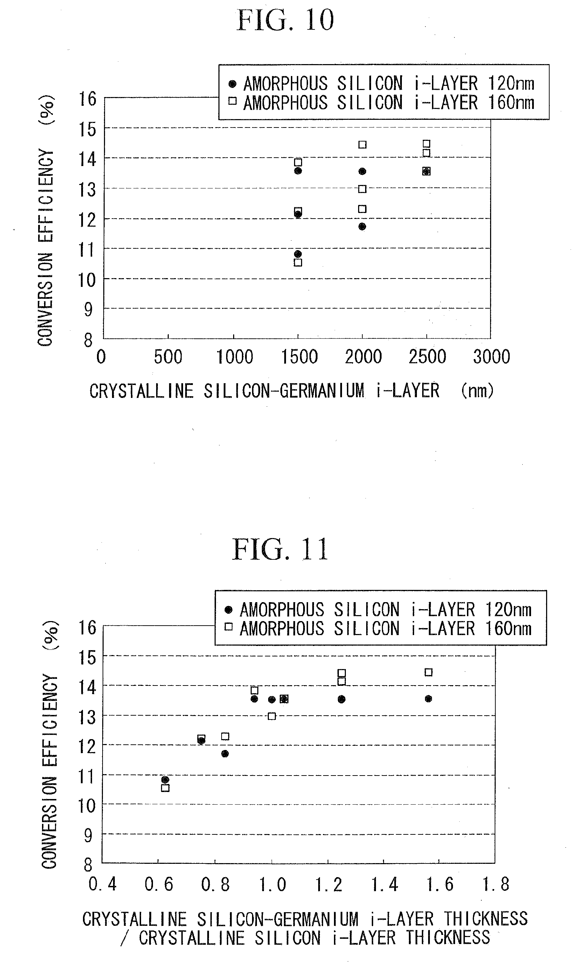

FIG. 9 is a graph illustrating the relationship between the thickness of the crystalline silicon i-layer of the second cell layer and the conversion efficiency for a solar cell of example 2. In the figure, the horizontal axis represents the thickness of the crystalline silicon i-layer, and the vertical axis represents the conversion efficiency. FIG. 10 is a graph illustrating the relationship between the thickness of the crystalline silicon-germanium i-layer of the third cell layer and the conversion efficiency for a solar cell of example 2. In the figure, the horizontal axis represents the thickness of the crystalline silicon-germanium i-layer, and the vertical axis represents the conversion efficiency. Even for identical values for the thickness of the crystalline silicon i-layer and the crystalline silicon-germanium i-layer, there was considerable variation in the conversion efficiency.

FIG. 11 is a graph illustrating the relationship between the ratio of the thickness of the crystalline silicon-germanium i-layer relative to the thickness of the crystalline silicon i-layer and the conversion efficiency for the solar cell of example 2. In the figure, the horizontal axis represents the thickness ratio, and the vertical axis represents the conversion efficiency. For thickness ratios within a range from not less than 0.9 to not more than 1.6, the conversion efficiency of the solar cell reached 13% or higher, indicating that a high conversion efficiency was able to be achieved.

### Example 3

Optical analysis calculations were performed using the same solar cell structural model as that of example 1. In example 3, the thickness of the amorphous silicon i-layer of the first cell layer 91 was set to 200 nm. The thickness of the crystalline silicon i-layer of the second cell layer 92 was set to an appropriate value within a range from 1,400 nm to 1,800 nm. The Ge composition ratio of the crystalline silicon-germanium i-layer of the third cell layer 93 was set to 40 atomic%, and the thickness was set to an appropriate value within a range from 1,400 nm to 1,800 nm.

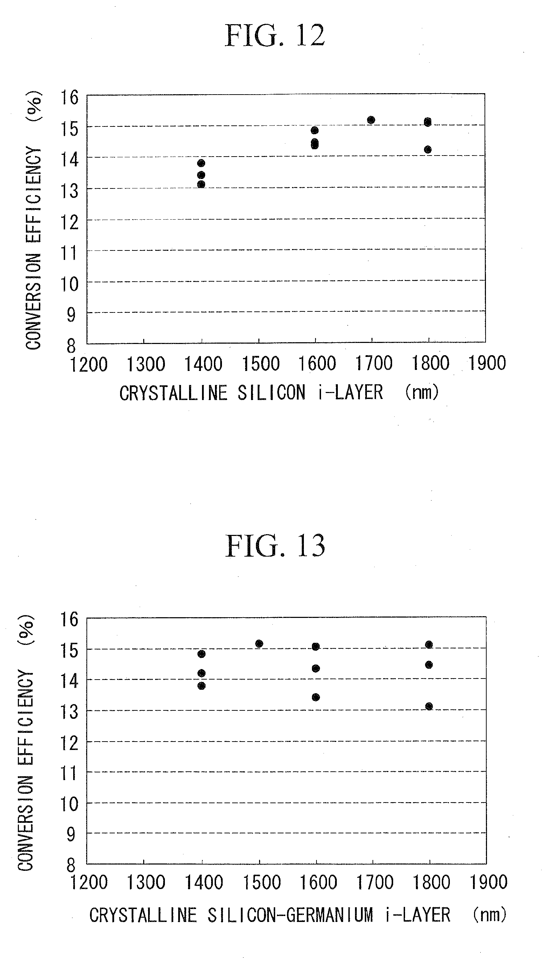

FIG. 12 is a graph illustrating the relationship between the thickness of the crystalline silicon i-layer of the second cell layer and the conversion efficiency for a solar cell of example 3. In the figure, the horizontal axis represents the thickness of the crystalline silicon i-layer, and the vertical axis represents the conversion efficiency. FIG. 13 is a graph illustrating the relationship between the thickness of the crystalline silicon-germanium i-layer of the third cell layer and the conversion efficiency for a solar cell of example 3.

In the figure, the horizontal axis represents the thickness of the crystalline silicon-germanium i-layer, and the vertical axis represents the conversion efficiency. Even for identical values for the thickness of the crystalline silicon i-layer and the crystalline silicon-germanium i-layer, there was considerable variation in the conversion efficiency.

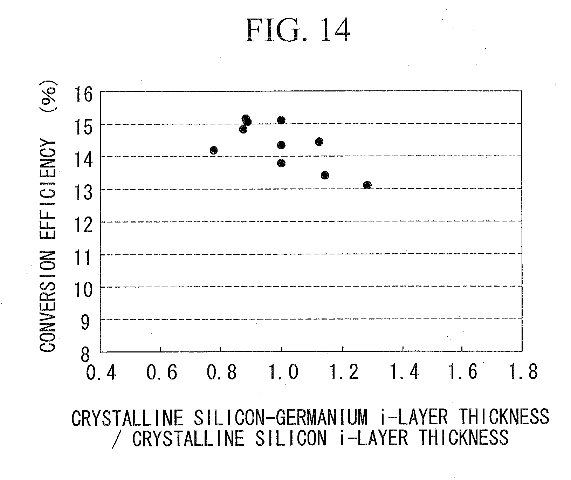

FIG. 14 is a graph illustrating the relationship between the ratio of the thickness of the crystalline silicon-germanium i-layer relative to the thickness of the crystalline silicon i-layer and the conversion efficiency for the solar cell of example 3. In the figure, the horizontal axis represents the thickness ratio, and the vertical axis represents the conversion efficiency. For thickness ratios within a range from not less than 0.8 to not more than 1.2, the conversion efficiency of the solar cell reached approximately 14 to 15%, indicating that an extremely high conversion efficiency was able to be achieved.

## Claims

1. A photovoltaic device comprising, on top of a substrate, a transparent electrode layer, a photovoltaic layer containing three stacked cell layers having pin junctions, and a back electrode layer, wherein
an incident section cell layer provided on a light-incident side among the cell layers has an amorphous silicon i-layer having a thickness of not less than 100 nm and not more than 200 nm,
a bottom section cell layer provided on an opposite side from the light-incident side has a crystalline silicon-germanium i-layer having a thickness of not less than 700 nm and not more than 1,600 nm, and a ratio of germanium atoms relative to a sum of germanium atoms and silicon atoms within the crystalline silicon-germanium i-layer is not less than 15 atomic% and not more than 25 atomic%, and
a middle section cell layer provided between the incident section cell layer and the bottom section cell layer has a crystalline silicon i-layer having a thickness of not less than 800 nm and not more than 2,000 nm.

2. The photovoltaic device according to Claim 1, wherein a ratio of a thickness of the crystalline silicon-germanium i-layer relative to a thickness of the crystalline silicon i-layer is not less than 0.6 and not more than 1.0.

3. A photovoltaic device comprising, on top of a substrate, a transparent electrode layer, a photovoltaic layer containing three stacked cell layers having pin junctions, and a back electrode layer, wherein
an incident section cell layer provided on a light-incident side among the cell layers has an amorphous silicon i-layer having a thickness of not less than 150 nm and not more than 250 nm,
a bottom section cell layer provided on an opposite side from the light-incident side has a crystalline silicon-germanium i-layer having a thickness of not less than 1,000 nm and not more than 3,000 nm, and a ratio of germanium atoms relative to a sum of germanium atoms and silicon atoms within the crystalline silicon-germanium i-layer is not less than 25 atomic% and not more than 35 atomic%, and
a middle section cell layer provided between the incident section cell layer and the bottom section cell layer has a crystalline silicon i-layer having a thickness of not less than 1,000 nm and not more than 3,000 nm.

4. The photovoltaic device according to Claim 3, wherein a ratio of a thickness of the crystalline silicon-germanium i-layer relative to a thickness of the crystalline silicon i-layer is not less than 0.9 and not more than 1.6.

5. A photovoltaic device comprising, on top of a substrate, a transparent electrode layer, a photovoltaic layer containing three stacked cell layers having pin junctions, and a back electrode layer, wherein
an incident section cell layer provided on a light-incident side among the cell layers has an amorphous silicon i-layer having a thickness of not less than 150 nm and not more than 300 nm,
a bottom section cell layer provided on an opposite side from the light-incident side has a crystalline silicon-germanium i-layer having a thickness of not less than 1,000 nm and not more than 2,000 nm, and a ratio of germanium atoms relative to a sum of germanium atoms and silicon atoms within the crystalline silicon-germanium i-layer is not less than 35 atomic% and not more than 45 atomic%, and
a middle section cell layer provided between the incident section cell layer and the bottom section cell layer has a crystalline silicon i-layer having a thickness of not less than 1,000 nm and not more than 2,500 nm.

6. The photovoltaic device according to Claim 5, wherein a ratio of a thickness of the crystalline silicon-germanium i-layer relative to a thickness of the crystalline silicon i-layer is not less than 0.7 and not more than 1.2.

7. The photovoltaic device according to any one of Claims 1 to 6, further comprising an intermediate contact layer between the incident section cell layer and the middle section cell layer.

8. The photovoltaic device according to any one of Claims 1 to 7, further comprising a second transparent electrode layer between the bottom section cell layer and the back electrode layer.
